# DEMANDE DE BREVET EUROPEEN

(11) **EP 3 340 318 A1**
(43) Date de publication de la demande: **27.06.2018**
(21) Numéro de dépôt: 17209141.5
(22) Date de dépôt: 20.12.2017
(51) Int. Cl.: H01L 31/0747, H01L 31/0475, H01L 31/18

(54) **DISPOSITIF PHOTOVOLTAÏQUE ET PROCEDE DE FABRICATION ASSOCIE**

(30) Priorité: 21.12.2016 FR 1663029
(71) Demandeur: Commissariat à l'énergie atomique et aux énergies alternatives, 75015 Paris (FR)
(72) Inventeur: DANEL, Adrien, 73170 YENNE (FR); BANCEL, Stéphane, 38000 GRENOBLE (FR); GERRITSEN, Eric, 38190 BERNIN (FR); HARRISON, Samuel, 38530 PONTCHARRA (FR); MUNOZ, Maria-Delfina, 38380 SAINT CHRISTOPHE SUR GUIERS (FR)
(74) Mandataire: Brevalex

(57) **Abrégé**

L'invention concerne un dispositif photovoltaïque (100) comprenant un substrat support (200) qui comprend une face avant (210) et une face arrière (220); un élément photovoltaïque comprenant une première cellule photovoltaïque (410) et une seconde cellule photovoltaïque (510), la première cellule photovoltaïque comprenant une première région émettrice (401) et une première région collectrice (402) disposées, respectivement, sur les faces avant et arrière, la seconde cellule photovoltaïque comprenant une seconde région collectrice (501) et une seconde région émettrice (502) disposées, respectivement, sur les faces avant et arrière, la première cellule photovoltaïque et la seconde cellule photovoltaïque étant disposées côte-à-côte, et connectées au moyen d'un contact électrique avant reliant la première région émettrice avec la seconde région collectrice.

## Description

### DOMAINE TECHNIQUE

La présente invention concerne un dispositif photovoltaïque comprenant au moins une première cellule photovoltaïque à hétérojonction et au moins une seconde cellule photovoltaïque à hétérojonction formées sur un substrat support.

### ART ANTÉRIEUR

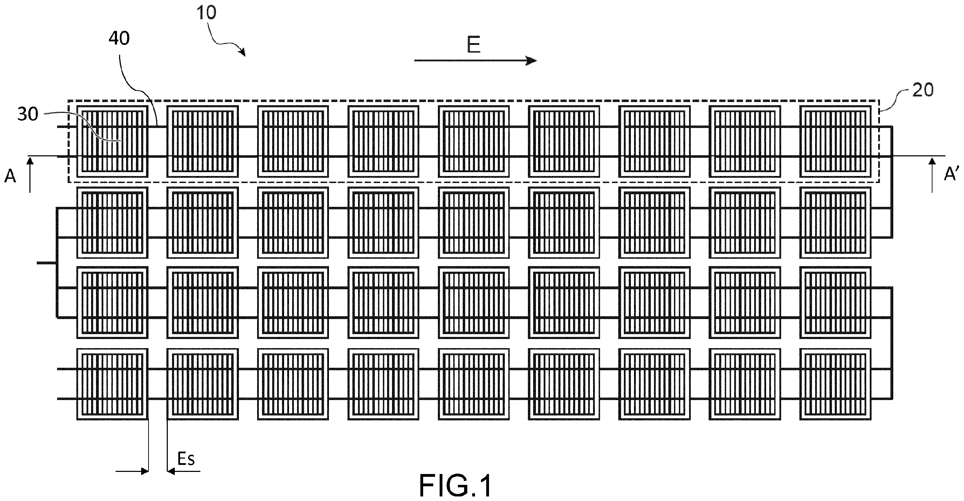

Un panneau photovoltaïque 10 présenté à la figure 1 comprend, en général, une pluralité de rangées 20 de cellules photovoltaïques 30, s'étendant chacune selon une direction d'élongation E, et parallèles entre elles.

L'ensemble des cellules photovoltaïques 30 sont connectées en série par l'intermédiaire de rubans conducteurs 40 reliant, chacun, la face avant 31 d'une cellule photovoltaïque avec la face arrière 32 d'une autre cellule photovoltaïque qui lui est adjacente. Un espacement Es, typiquement compris entre 3 et 4 mm, entre les cellules photovoltaïques 30 permet le passage des rubans conducteurs 40.

Cependant, ce mode de connexion n'est pas satisfaisant.

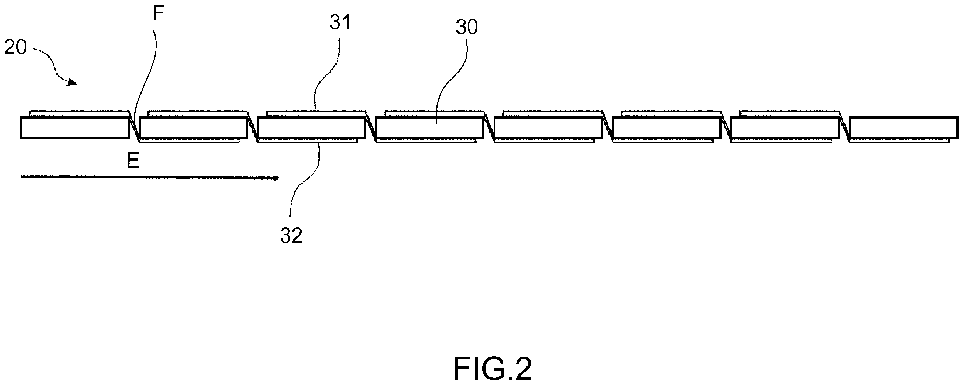

En effet, le passage des rubans conducteurs 40 au niveau des espacements Es entre les cellules photovoltaïques 30 est la principale source de défaillances. Plus particulièrement, et comme représenté sur la figure 2, les rubans conducteurs 40 présentent une zone de fragilisation F, induite par leur déformation au niveau des espacements Es, qui est susceptible de rompre sous l'action répétée de contraintes, notamment des contraintes induites par l'exposition des panneaux photovoltaïques à de fortes variations de température.

Par ailleurs, les espacements Es entre cellules photovoltaïques 30 ne participent pas à la conversion de la lumière en tension électrique. Ces espacements Es, aussi appelés « zones blanches », réduisent ainsi l'efficacité du panneau photovoltaïque 10.

En outre, la mise en place des rubans conducteurs 40 lors de l'assemblage des cellules photovoltaïques 30 sur un panneau photovoltaïque 10 impose des étapes de manipulations desdites cellules photovoltaïques 30 qui sont une source de défectivité affectant directement les performances du panneau photovoltaïque 10.

Les inconvénients ainsi mentionnés sont exacerbés dès lors que l'on souhaite augmenter le nombre de cellules photovoltaïques 30 sur un panneau photovoltaïque 10 en réduisant la taille desdites cellules photovoltaïques 30.

La considération de cellules photovoltaïques 30 de plus petite taille procure nombre d'avantages, parmi lesquels on compte la réduction du courant et par voie de conséquence la réduction des pertes ohmiques, mais également la possibilité d'augmenter la tension électrique délivrée par un panneau photovoltaïque 10 sans en augmenter la taille.

Il est alors primordial de réduire l'impact des inconvénients précités, et ce particulièrement dès lors que l'utilisation de cellules de plus petite taille est envisagée.

Un but de la présente invention est alors de proposer un dispositif photovoltaïque comprenant des cellules photovoltaïques, et permettant d'améliorer la fiabilité des panneaux photovoltaïques.

Un autre but de l'invention est de proposer un dispositif photovoltaïque comprenant des cellules photovoltaïques permettant de simplifier l'assemblage desdits panneaux.

Un autre but de l'invention est également de proposer un dispositif photovoltaïque permettant d'améliorer l'efficacité des panneaux photovoltaïques.

Un autre but de l'invention est de proposer un dispositif photovoltaïque permettant de considérer des cellules photovoltaïques de plus petite taille sans pour autant complexifier le procédé d'assemblage des panneaux photovoltaïques.

### EXPOSÉ DE L'INVENTION

Les buts de l'invention sont, au moins en partie, atteints par un dispositif photovoltaïque comprenant :
- un substrat support qui comprend deux faces essentiellement parallèles dites, respectivement, face avant et face arrière,
- au moins un élément photovoltaïque comprenant une première cellule photovoltaïque à hétérojonction et une seconde cellule photovoltaïque à hétérojonction, la première cellule photovoltaïque à hétérojonction comprenant une première région émettrice et une première région collectrice disposées, respectivement, sur la face avant et sur la face arrière du substrat, la seconde cellule photovoltaïque à hétérojonction comprenant une seconde région collectrice et une seconde région émettrice disposées, respectivement, sur la face avant et sur la face arrière du substrat la première cellule photovoltaïque à hétérojonction et la seconde cellule photovoltaïque à hétérojonction étant disposées côte-à-côte, et électriquement connectées au moyen d'un contact électrique avant reliant la première région émettrice avec la seconde région collectrice.

Il est entendu, sans qu'il soit nécessaire de le préciser que la première cellule photovoltaïque et la seconde cellule photovoltaïque d'un élément photovoltaïque sont électriquement connectées en série.

On comprend par face avant la face du dispositif destinée à recevoir l'ensoleillement principal.

Ainsi, la disposition de l'au moins une première cellule photovoltaïque et de l'au moins une seconde cellule photovoltaïque permet de s'affranchir de rubans conducteur connectant une face avant d'une cellule avec une face arrière d'une autre cellule, et des problèmes de fiabilité qui leurs sont associés.

Par ailleurs, il est également possible de réduire, voire de supprimer, les zones blanches, et ainsi améliorer l'efficacité des panneaux photovoltaïques.

En outre, il est également possible de considérer des cellules de plus petite taille sans pour autant devoir exécuter des étapes de découpe supplémentaires desdites cellules avant l'assemblage d'un panneau photovoltaïque, et ainsi éviter toute défectivité qui pourrait être associée à ce type d'étape.

Enfin, le dispositif photovoltaïque selon l'invention ne nécessite pas de moyen d'isolation pour isoler électriquement l'au moins une première cellule photovoltaïque de l'au moins une seconde cellule photovoltaïque.

Selon un mode de mise en oeuvre, le dispositif comprend une pluralité d'éléments photovoltaïques électriquement connectés en série par au moins un contact électrique arrière, chaque contact électrique arrière connectant électriquement la première région collectrice d'un élément photovoltaïque, dit premier élément photovoltaïque, à la seconde région émettrice d'un autre élément photovoltaïque immédiatement adjacent au premier élément photovoltaïque.

Selon un mode de mise en oeuvre, le contact électrique arrière comporte une première section de contact électrique arrière et une seconde section de contact électrique arrière, en contact, respectivement, avec la première région collectrice d'un élément photovoltaïque, dit premier élément photovoltaïque, à la seconde région émettrice d'un autre élément photovoltaïque immédiatement adjacent au premier élément photovoltaïque, chaque contact électrique arrière comprend également une section de contact métallique arrière qui relie la première section de contact électrique arrière et la seconde section de contact électrique arrière dudit contact électrique arrière, avantageusement la section de contact métallique arrière comprend des doigts métalliques arrières.

Selon un mode de mise en oeuvre, la première section de contact électrique arrière et la seconde section de contact électrique arrière sont formés par une couche en oxyde conducteur transparent, de manière avantageuse, l'oxyde conducteur transparent comprend au moins un des matériaux choisi parmi : de l'oxyde d'indium comprenant avantageusement au moins un des éléments choisi parmi : l'étain, l'hydrogène, le tungstène, le cérium, le cadmium ; ou de l'oxyde de zinc comprenant au moins un des éléments choisi parmi : l'aluminium, l'indium, le bore.

Selon un mode de mise en oeuvre, le contact électrique avant comprend une première section de contact électrique avant et une seconde section de contact électrique avant, en contact, respectivement, avec la première région émettrice, et la seconde région collectrice d'un élément photovoltaïque, le contact électrique avant comprend en outre une section de contact métallique avant qui relie la première section de contact électrique avant et la seconde section de contact électrique dudit contact électrique avant, avantageusement la section de contact métallique avant comprend des doigts métalliques avants.

Selon un mode de mise en oeuvre, la première section de contact électrique avant et la seconde section de contact électrique avant sont formés par une couche en oxyde conducteur transparent, de manière avantageuse, l'oxyde conducteur transparent comprend au moins un des matériaux choisi parmi : de l'oxyde d'indium comprenant avantageusement au moins un des éléments choisi parmi : l'étain, l'hydrogène, le tungstène, le cérium, le cadmium ; ou de l'oxyde de zinc comprenant au moins un des éléments choisi parmi : l'aluminium, l'indium, le bore.

Selon un mode de mise en oeuvre, le substrat support est intégralement recouvert d'une couche de passivation de sorte que les premières régions émettrice et collectrice et les secondes régions émettrice et collectrice reposent sur ladite couche de passivation.

Selon un mode de mise en oeuvre, la couche de passivation comprend du silicium amorphe, avantageusement le silicium amorphe comprend un niveau de dopage inférieur à 10²⁰ at/cm³, encore plus avantageusement le silicium amorphe est intrinsèque.

Selon un mode de mise en oeuvre, la première région émettrice et la seconde région collectrice de l'élément photovoltaïque sont espacées d'une distance a1 inférieure à 2 mm, avantageusement d'une distance nulle.

Selon un mode de mise en oeuvre, la première région collectrice et la seconde région émettrice de l'élément photovoltaïque sont espacées d'une distance a2 inférieure à 2 mm, avantageusement d'une distance égale à 1 mm.

Selon un mode de mise en oeuvre, dans lequel la première section de contact électrique avant et la seconde section de contact électrique avant du contact électrique avant sont espacées d'une distance b1 comprise entre 0 mm et 2 mm, avantageusement entre 0,5 mm et 2 mm.

Selon un mode de mise en oeuvre, le substrat support comprend du silicium cristallin avec un niveau de dopage, de type n ou de type p, compris entre 10¹³ atm/cm³ et 10¹⁷ atm/cm³.

Selon un mode de mise en oeuvre, la une première région émettrice et la seconde région émettrice comprennent du silicium amorphe avec un niveau dopage de type p compris 10²¹ at/cm³ et 5x10²² at/cm³.

Selon un mode de mise en oeuvre, la première région collectrice et la seconde région collectrice comprennent du silicium amorphe avec un niveau dopage de type n compris 10²¹ at/cm³ et 5x10²² at/cm³.

Selon un mode de mise en oeuvre, les surfaces de l'au moins une première région émettrice, de l'au moins une première région collectrice, de l'au moins une seconde région collectrice et de l'au moins une seconde région émettrice sont ajustées de sorte que la première cellule photovoltaïque et la seconde cellule photovoltaïque présentent des performances équivalentes.

L'invention concerne également un panneau photovoltaïque comprenant un support sur lequel sont disposés une pluralité de dispositifs photovoltaïques, le panneau photovoltaïque comprenant au moins un contact additionnel connectant électriquement une première région collectrice d'extrémité d'un dispositif photovoltaïque, dit premier dispositif photovoltaïque, avec une seconde région émettrice d'extrémité d'un autre dispositif photovoltaïque adjacent au premier dispositif photovoltaïque, La première région collectrice d'extrémité étant une région collectrice disposée en extrémité de la chaine de connections électriques en série du premier dispositif photovoltaïque, et la seconde région émettrice d'extrémité étant disposée en extrémité de la chaine de connections électriques en série de l'autre dispositif photovoltaïque.

L'invention concerne également un procédé de fabrication du dispositif photovoltaïque, le dispositif photovoltaïque comprenant une première cellule photovoltaïque à hétérojonction et une seconde cellule photovoltaïque à hétérojonction, la première cellule photovoltaïque à hétérojonction comprenant une première région émettrice et une première région collectrice disposées, respectivement, sur une face avant et sur une face arrière d'un substrat support, la seconde cellule photovoltaïque à hétérojonction comprenant une seconde région collectrice et une seconde région émettrice disposées, respectivement, sur la face avant et sur la face arrière, le procédé comprenant les étapes suivantes :
a) Une étape qui consiste à fournir le substrat support comprenant deux faces essentiellement parallèles, dites face avant et face arrière,
b) une étape qui consiste à former la première région émettrice et la seconde région collectrice sur la face avant,
c) une étape qui consiste à former la première région collectrice et la seconde région émettrice sur la face arrière,
d) une étape qui consiste à former au moins un contact électrique avant (600) reliant la première région collectrice avec la seconde région émettrice.

Selon un mode de mise en oeuvre, le dispositif photovoltaïque comprend une pluralité d'éléments photovoltaïques, le procédé comprenant une étape e) qui consiste à former au moins un contact électrique arrière, le contact électrique arrière connectant électriquement la première région collectrice d'un élément photovoltaïque, dit premier élément photovoltaïque, à la seconde région émettrice d'un autre élément photovoltaïque immédiatement adjacent au premier élément photovoltaïque.

Selon un mode de mise en oeuvre, le procédé comprend en outre une étape a1) de formation d'une couche de passivation recouvrant intégralement le substrat support et de sorte que les premières régions émettrice et collectrice et les secondes régions émettrice et collectrice reposent sur ladite couche de passivation, avantageusement, la couche de passivation est une couche de silicium amorphe formée par une technique de dépôt chimique en phase vapeur assisté par plasma.

Selon un mode de mise en oeuvre, les étapes b) et c) sont exécutées par la technique de dépôt chimique en phase vapeur assisté par plasma.

Selon un mode de mise en oeuvre, l'étape de d) est exécutée par une technique de dépôt physique ou chimique, en phase vapeur ou non, assisté par plasma ou non, ou par dépôt d'impression

### BRÈVE DESCRIPTION DES DESSINS

D'autres caractéristiques et avantages apparaîtront dans la description qui va suivre des modes de mise en oeuvre du dispositif photovoltaïque selon l'invention, donnés à titre d'exemples non limitatifs, en référence aux dessins annexés dans lesquels :
- la figure 1 est une représentation schématique, en vue de dessus, d'un panneau photovoltaïque, comprenant une pluralité de rangées de cellules photovoltaïque, connu de l'état de la technique,
- la figure 2 est une représentation schématique des connexions électriques au sein d'une rangée de cellules photovoltaïques selon l'état de la technique, plus particulièrement, la figure 2 représente les connexions électriques entre cellules photovoltaïques, selon un plan de coupe AA (indiqué sur la figure 1), au sein d'une rangée de cellules photovoltaïques,
- la figure 3a est une représentation schématique, selon un plan de coupe, d'un dispositif photovoltaïque selon un premier mode de réalisation de l'invention,
- la figure 3b est une représentation schématique, selon un plan de coupe, d'un dispositif photovoltaïque selon un second mode de réalisation de l'invention les doigts métalliques avants et arrières ne sont pas représentés sur la figure 3b),
- la figure 3c est une représentation schématique, selon un plan de coupe, d'un dispositif photovoltaïque selon l'invention et destiné à illustrer les distances a1, a1b, a2, a2b, b1, b1b, b2, et b2b (les doigts métalliques avants et arrières ne sont pas représentés sur la figure 3c),

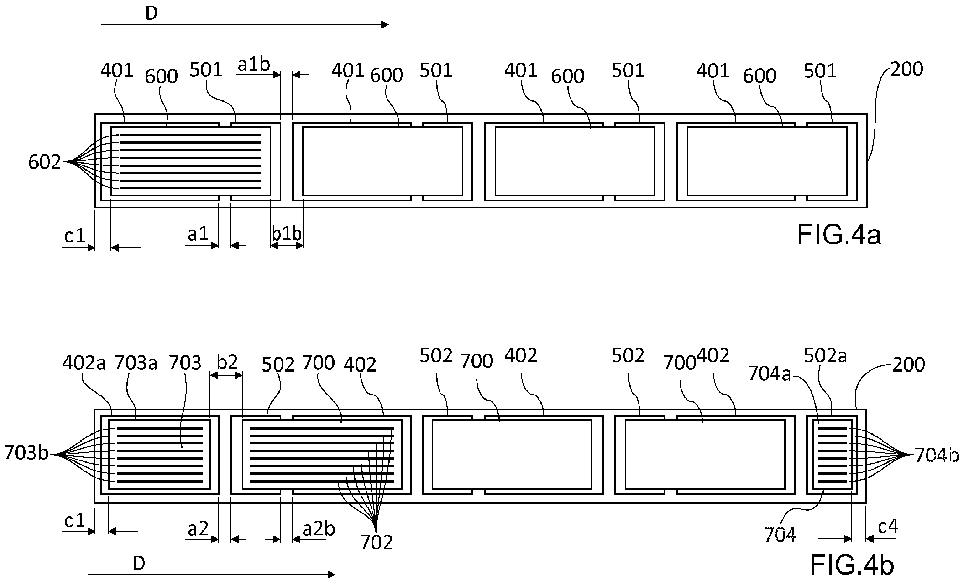

- les figures 4a et 4b sont des représentions schématiques d'un dispositif photovoltaïque selon la face avant (figure 4a) et selon la face arrière (figure 4b) du substrat support, selon un mode de réalisation de l'invention, les premières régions émettrices et les secondes régions collectrices étant agencées en rangée, les sections de contact métallique avant et arrière (les sections de contact métallique avant et arrière étant ici représentées sous formes de doigts métalliques avants et arrières) n'étant représentés que pour, respectivement, un seul contact électrique avant et un seul contact électrique arrière, sur la figure 4a, la distance a1 est positive, la distance b1 est inférieure ou égale à zéro, sur la figure 4b, la distance b2 est positive et la distance b2b est inférieure ou égale à zéro,

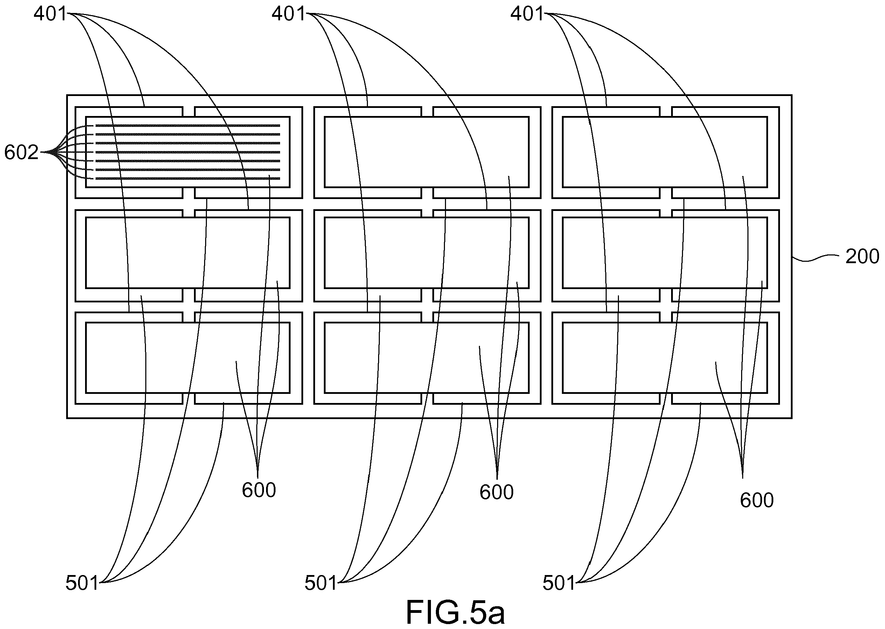

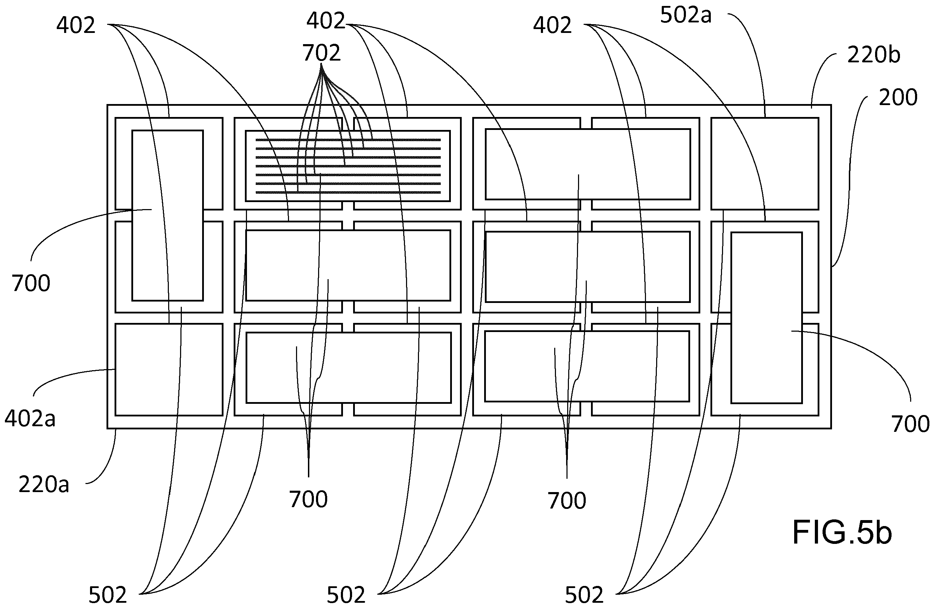

- les figures 5a et 5b sont des représentations schématiques d'un dispositif photovoltaïque selon la face avant (figure 5a) et selon la face arrière (figure 5b) du substrat support, selon un mode de réalisation de l'invention, les premières régions émettrices et les secondes régions collectrices étant agencées en matrice, les sections de contact métallique avant et arrière (les sections de contact métallique avant et arrière étant ici représentées sous formes de doigts métalliques avants et arrières) n'étant représentés que pour, respectivement, un seul contact électrique avant et un seul contact électrique arrière,
- la figure 6 est une représentation schématique d'un panneau photovoltaïque comprenant une pluralité de dispositifs photovoltaïques selon l'invention.

### EXPOSÉ DÉTAILLÉ DE MODES DE RÉALISATION PARTICULIERS

L'invention décrite de manière détaillée ci-dessous met en oeuvre un dispositif photovoltaïque comprenant une pluralité de cellules photovoltaïques à hétérojonction. Plus particulièrement, le dispositif photovoltaïque comprend au moins:
- une première cellule photovoltaïque à hétérojonction, comprenant un émetteur, dit premier émetteur, et un collecteur, dit premier collecteur, disposés, respectivement, sur une face avant et une face arrière d'un substrat support,
- et une seconde cellule photovoltaïque à hétérojonction, adjacente à la première cellule photovoltaïque, comprenant un émetteur, dit second émetteur, et un collecteur, dit second collecteur, disposés, respectivement, sur la face arrière et la face avant du même substrat support.

L'agencement ainsi proposé permet de réaliser une connexion électrique en série entre la première cellule photovoltaïque et la seconde cellule photovoltaïque de manière monolithique. Autrement dit, il n'est pas nécessaire de disposer des rubans conducteurs connectant une face avant d'une cellule photovoltaïque avec la face arrière d'une autre cellule photovoltaïque, permettant ainsi de corriger les défaillances constatées au niveau des rubans conducteurs connus de l'état de la technique.

Par cellule photovoltaïque à hétérojonction, nous entendons une cellule photovoltaïque comprenant un collecteur et un émetteur reposant chacun sur une face différente d'un substrat support, sensiblement au droit l'un de l'autre, et dont l'émetteur et/ou le collecteur est fait d'un matériau différent du substrat support.

Par matériau différent, nous entendons également deux matériaux de même composition chimique mais présentant une structure cristallographique différente, par exemple du silicium monocristallin et du silicium amorphe sont considérés comme des matériaux différents au sens de la présente invention.

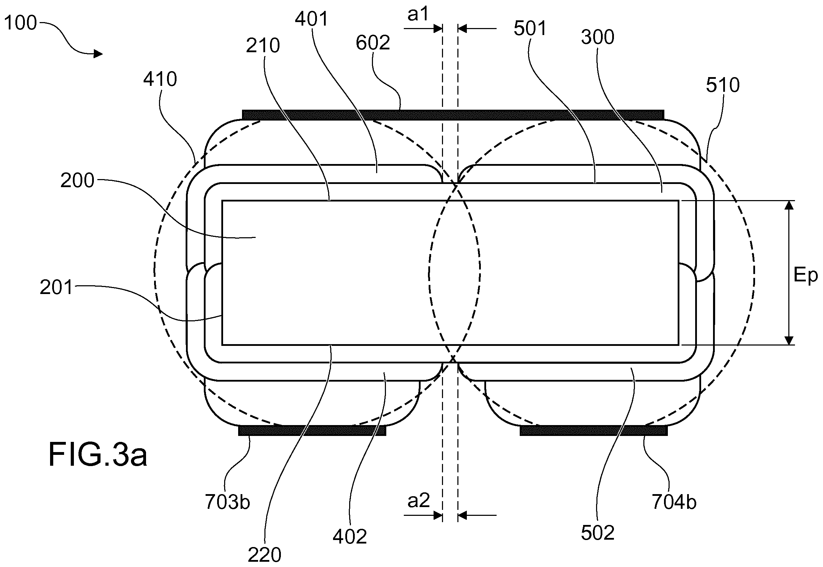

Sur les figures 3a, 3b, 3c, 4a, 4b, 5a et 5b, on peut voir un exemple de réalisation du dispositif photovoltaïque 100 selon l'invention.

Le dispositif photovoltaïque 100 selon l'invention comprend un substrat support 200.

Le substrat support 200 comprend deux faces essentiellement parallèles dites face avant 210 et face arrière 220.

Il est entendu sans qu'il soit nécessaire de le préciser que le substrat support 200 a une surface planaire, autrement dit les faces avant 210 et arrière 220 sont planaires et reliées par un contour 201.

L'épaisseur Ep, du substrat support 200, est définie par la distance séparant les faces avant 210 et arrière 220.

De manière avantageuse, l'épaisseur Ep du substrat support peut être comprise entre 50 µm et 1mm, par exemple 150 µm.

Les faces avant 210 et arrière 220 peuvent être de forme sensiblement carrée ou sensiblement rectangulaire. Cependant la mise en oeuvre de l'invention ne doit pas se limiter à ces deux formes.

Les faces avant 210 et arrière 220 peuvent présenter une longueur comprise entre 10 mm et 300 mm, par exemple 156,75 mm, et une largeur comprise entre 10 mm et 300 mm, par exemple 156,75 mm.

De manière avantageuse, le substrat support 200 peut comprendre au moins un des matériaux choisi parmi : silicium monocristallin, germanium monocristallin, arséniure de gallium monocristallin, silicium multi cristallin.

Le substrat support 200 peut avantageusement comprendre un niveau de dopage compris entre 10¹³ atm/cm³ et 10¹⁷ atm/cm³.

Par comprendre un niveau de dopage, nous entendons comprendre des espèces dopantes destinées à modifier les propriétés électriques du matériau ou de la couche ou du substrat dans lequel elles se trouvent.

Les espèces dopantes peuvent être de type n (espèces donneuses d'électrons), ou de type p (espèces donneuses de « trous »).

Une espèce dopante de type n, pour le silicium, peut par exemple être du phosphore ou de l'arsenic.

Une espèce dopante de type p, pour le silicium, peut par exemple être du Bore.

Le substrat support 200 peut avantageusement comprendre une couche de passivation 300 recouvrant intégralement sa surface.

Par recouvrir intégralement sa surface, on entend recouvrir la face avant 210, la face arrière 220 et le contour 201.

La couche de passivation 300 peut avantageusement comprendre du silicium amorphe. Le silicium amorphe peut comprendre un niveau dopage inférieur à 10²⁰ at/cm³.

Toujours de manière avantageuse, la couche de passivation 300 peut comprendre du silicium amorphe intrinsèque, autrement dit dépourvu d'espèces dopantes.

La couche de passivation 300 peut être formée pour une technique de formation de couche connue de l'homme du métier.

Par exemple, la couche de passivation 300 peut être formée par une technique de dépôt chimique en phase vapeur assistée par plasma (« PECVD » ou « Plasma Enhanced Chemical Vapor Déposition » selon la terminologie Anglo-Saxonne).

Par exemple, une couche de passivation 300 comprenant du silicium amorphe peut être formée par PECVD, à une température comprise entre 100°C et 300°C, et comme précurseur du Silane ou des chloro silane.

L'épaisseur de la couche de passivation 300 peut être comprise entre 1 nm et 30 nm.

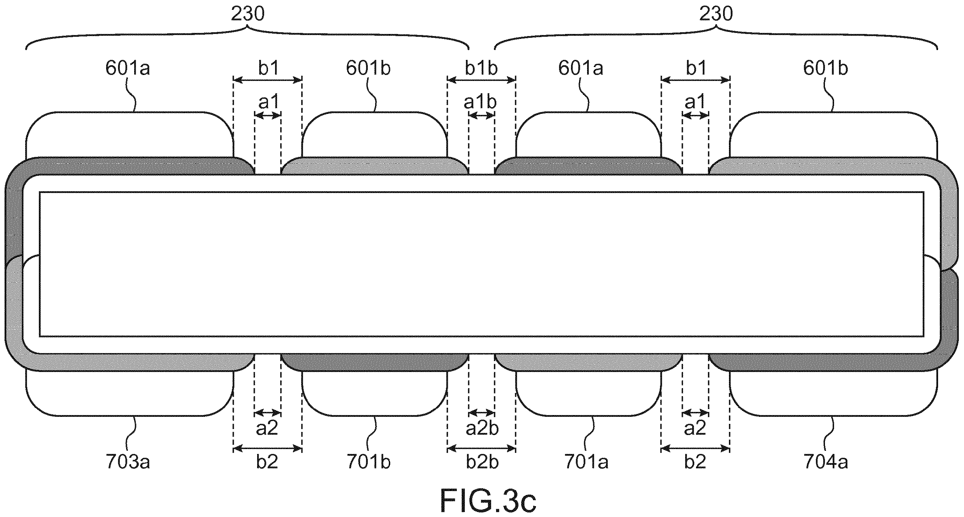

Le dispositif photovoltaïque 100 comprend au moins un élément photovoltaïque 230 (fig. 3c) comprenant une première cellule photovoltaïque à hétérojonction 410 et une seconde cellule photovoltaïque à hétérojonction 510 (fig. 3a).

La première cellule photovoltaïque à hétérojonction 410 comprend une première région émettrice 401 et une première région collectrice 402 disposées, respectivement, sur la face avant 210 et sur la face arrière 220.

La seconde cellule photovoltaïque à hétérojonction 510 comprend une seconde région collectrice 501 et une seconde région émettrice 502 disposées, respectivement, sur la face avant 210 et sur la face arrière 220.

Une première région émettrice 401 adjacente au contour 201 peut déborder sur ledit contour (201).

Une seconde région collectrice 501 adjacente au contour 201 peut déborder sur ledit contour (201).

Une première région collectrice 402 adjacente au contour 201 peut déborder sur ledit contour (201).

Une seconde région émettrice 502 adjacente au contour 201 peut déborder sur ledit contour (201).

La première cellule photovoltaïque à hétérojonction 410 et la seconde cellule photovoltaïque à hétérojonction 510 de l'élément photovoltaïque 230 sont connectées électriquement par un contact électrique avant 600 (fig. 4a et 5a).

Plus particulièrement, le contact électrique avant 600 connecte électriquement la première région émettrice 401 avec la seconde région collectrice 501 de l'élément photovoltaïque 230.

La première région émettrice 401 et la seconde région collectrice 501 peuvent être de forme polygonale, avantageusement de forme carrée ou rectangulaire.

La première région émettrice 401 et la seconde région collectrice 501 sont disposées côte-à-côte.

La première région collectrice 402 et la seconde région émettrice 502 sont disposées côte-à-côte.

Par disposées côte-à-côte, on entend que la première région émettrice 401 et la seconde région collectrice 501 partagent un côté. Par partager un côté, on entend qu'un côté d'une région émettrice est adjacent et à proximité d'un côté d'une région collectrice. Autrement dit, un côté de la première région émettrice 401 est parallèle et à proximité d'un côté de la seconde région collectrice 501. Nous assimilons également tout au long de la description la distance entre une région émettrice et une région collectrice côte-à-côte à la distance « a » de leurs côtés adjacents.

Plus particulièrement, nous notons « distance a1 » (figures 3a et 3c) la distance entre la première région émettrice 401 et la seconde région collectrice 501 d'un élément photovoltaïque 230.

Nous notons « distance a2 » la distance entre la première région collectrice 402 et la seconde région émettrice 502 d'un élément photovoltaïque 230 (figure 3a et 3c).

De manière particulièrement avantageuse, la distance a1 peut être inférieure à 2 mm, avantageusement égale à 1 mm, encore plus avantageusement nulle.

La première région émettrice 401 et la seconde région collectrice 501 d'un même élément photovoltaïque 230 peuvent être en recouvrement, autrement dit la distance a1 est négative.

Toujours de manière avantageuse, la distance a2 est strictement positive, et peut être inférieure à 2 mm, avantageusement égale à 1 mm.

Dès lors que le dispositif photovoltaïque 100 comprend une pluralité d'éléments photovoltaïques 230, ces derniers sont électriquement connectés en série par au moins un contact électrique arrière 700 (fig. 4b et 5b).

Plus particulièrement, chaque contact électrique arrière 700 connecte électriquement la première région collectrice 402 d'un élément photovoltaïque 230, dit premier élément photovoltaïque, à la seconde région émettrice 502 d'un autre élément photovoltaïque 230 immédiatement adjacent au premier élément photovoltaïque.

Les éléments photovoltaïques 230 sont alors disposés côte-à-côte de sorte que les premières régions émettrices 401 et les secondes régions collectrices 501 sont disposées côte-à-côte et en alternance.

Par disposées en alternance, on entend une succession régulière d'une première région émettrice 401 et d'une seconde région collectrice 501. Autrement dit une première région émettrice 401 donnée ne partage aucun côté avec une autre première région émettrice 401. De manière équivalente, une seconde région collectrice 501 donnée ne partage aucun côté avec une autre seconde région conductrice.

Les premières régions émettrices 401 et les secondes régions collectrices 501 peuvent être disposées en alternance selon une rangée s'étendant une direction D de la face avant 210 (figures 4a et 4b).

Aussi, l'alternance ne se limite pas, au sens de la présente invention, à une seule direction de la face avant 210.

Ainsi, les premières régions émettrices 401 et les secondes régions collectrices 501 peuvent être disposées en alternance selon une matrice (figure 5a et 5b).

Il est évident, sans qu'il soit nécessaire de le préciser que les premières régions collectrices 402 et les secondes régions émettrices 502 sont également disposées côte-à-côte et en alternance sur la face arrière 220.

Ainsi, chaque première région émettrice 401 et la première région collectrice 402, essentiellement au droit de ladite première région émettrice 401, forment avec le substrat support 200 une première cellule photovoltaïque à hétérojonction 410.

De la même manière, chaque seconde région collectrice 501 et la seconde région émettrice 502, essentiellement au droit de ladite seconde région collectrice 501, forment une seconde cellule photovoltaïque à hétérojonction 510.

Toujours dans le cadre d'une pluralité d'éléments photovoltaïques 230, nous notons « distance a1b » (figure 3c) la distance entre la première région émettrice 401 d'un élément photovoltaïques 230, dit premier élément, et la seconde région collectrice 501 d'un autre élément photovoltaïque 230 immédiatement adjacent au premier élément. Il est entendu que la première région émettrice 401 de l'élément photovoltaïques 230, dit premier élément, et la seconde région collectrice 501 de l'autre élément photovoltaïque 230 sont côte-à-côte sur la face avant 210.

La distance a1b est strictement positive, et peut être inférieure à 2 mm, avantageusement égale à 1 mm.

Dès lors que la distance a1 est non nulle et positive, les distances a1 et a1b peuvent être identiques.

De manière équivalente, nous notons « distance a2b » (figure 3c) la distance entre la première région collectrice 402 d'un élément photovoltaïque 230, dit premier élément photovoltaïque, et la seconde région émettrice 502 d'un autre élément photovoltaïque 230 immédiatement adjacent au premier élément. Il est entendu que la première région collectrice 402 de l'élément photovoltaïque 230, dit premier élément photovoltaïque, et la seconde région émettrice 502 de l'autre élément photovoltaïque sont disposées côte-à-côte sur la face arrière 220.

La distance a2b peut être inférieure à 2 mm, avantageusement égale à 1 mm, encore plus avantageusement nulle.

La première région collectrice 402 de l'élément photovoltaïque 230, dit premier élément photovoltaïque, et la seconde région émettrice 502 de l'autre élément photovoltaïque peuvent être en recouvrement, autrement dit, la distance a2b peut être négative.

Dès lors que la distance a2b est non nulle et positive, les distances a2 et a2b peuvent être identiques, notamment si la connexion entres des régions adjacentes est réalisées par connecteurs métalliques (sérigraphie).

De manière avantageuse, les distances a1 et a2b sont égales, encore plus avantageusement, ces deux distances sont négatives.

Les première et seconde régions émettrices 401 et 502, et les première et seconde régions collectrices 402 et 501 peuvent être formées par une technique de dépôt ou de formation de couches, par exemple par PECVD. Leur formation peut impliquer des techniques de masquage, de photolithographie, et de sérigraphie connues de l'homme du métier, et qui ne sont, par conséquent, pas décrites en détails dans la présente demande.

Les première et seconde régions émettrices 401 et 502, et les première et seconde régions collectrices 402 et 501 peuvent être des couches de silicium amorphe dopé n ou P.

Par exemple, les première et seconde régions émettrices 401 et 502 ont un dopage de type p, le substrat support 200 comprend un dopage de type n, et les première et seconde régions collectrices 402 et 501 ont un dopage de type n.

De manière avantageuse, les premières régions émettrices 401 et les secondes régions émettrices 502 comprennent du silicium amorphe avec un niveau dopage de type p (par exemple du Bore) compris entre 10²¹ at/cm³ et 5x10²² at/cm³.

Toujours de manière avantageuse, les premières régions collectrices 402 et les secondes régions collectrices 501 comprennent du silicium amorphe avec un niveau dopage de type n (par exemple du phosphore ou de l'arsenic) compris 10²¹ at/cm3et 5x10²² at/cm³.

De manière particulièrement avantageuse, les premières régions émettrices 401 et les secondes régions émettrices 502 sont de forme rectangulaire ou carrée.

Toujours de manière particulièrement avantageuse, les premières régions collectrices 402 et les secondes régions collectrices 501 sont de forme rectangulaire ou carrée.

Ainsi toutes les zones blanches susceptibles d'être présentes au niveau du dispositif photovoltaïque peuvent être réduites (dès lors que les grandeurs a1 et a2b sont nulles, ou inférieures à zéro). Il n'est pas nécessaire, selon la présente invention, de disposer de moyens d'isolation électriques entre les régions de polarité différentes voisines (les régions de polarité différente étant des régions émettrice et collectrice) sur chacune des faces avant 210 et arrière 220. Un contact au niveau du côté qu'elles partagent peut également être envisagé sans nécessairement provoquer un court-circuit.

Les surfaces des premières régions émettrice 401 et collectrice 402, ainsi que les surfaces des secondes régions collectrices 501 et émettrice 502 peuvent être différentes. Plus particulièrement, lesdites surfaces peuvent être ajustées de sorte que la première cellule photovoltaïque 410 et la seconde cellule photovoltaïques 510 aient des performances sensiblement identiques, notamment concernant le courant photo-généré et collecté.

Par surface ajustée, on entend adapter l'étendue de la surface d'une des régions par rapport à la surface de l'autre région.

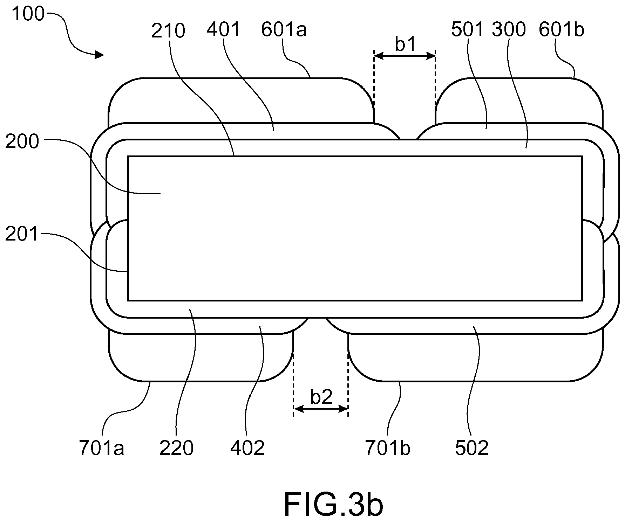

Le contact électrique avant 600 peut comprendre une première section de contact électrique avant 601a et une seconde section de contact électrique 601b, en contact, respectivement, avec la première région émettrice 401, et la seconde région collectrice 501 d'un élément photovoltaïque 230 (figure 3a et 3b).

Par définition (sans qu'il soit nécessaire de le préciser), la première section de contact électrique avant 601a et la seconde section de contact électrique avant 601b sont en forme de couche de matériau conducteur en recouvrement, au moins partiel, respectivement, de la première région émettrice 401 et de la seconde région collectrice 501.

La première section de contact électrique avant 601a et la seconde section de contact électrique avant 601b du contact électrique avant 600 sont côte-à-côte, et distantes d'une distance b1 (figures 3b et 3c).

La distance b1 peut être inférieure à 2 mm, ou avantageusement nulle ou négative (en recouvrement).

La première section de contact électrique avant 601a d'un élément photovoltaïque 230, dit premier élément photovoltaïque, et la seconde section de contact électrique avant 601b d'un autre élément photovoltaïque 230 immédiatement adjacent au premier élément photovoltaïque, sont distants d'une distance b1b (figure 3c).

La distance b1b est strictement positive, et avantageusement comprise entre 0,5 mm et 2 mm.

La première section de contact électrique avant 601a et la seconde section de contact électrique avant 601b peuvent, chacune, être formées par une couche d'oxyde transparent conducteur.

La couche d'oxyde transparent conducteur peut comprendre de l'oxyde d'indium, comprenant avantageusement au moins un des éléments choisi parmi l'hydrogène, le tungstène, le cérium, le cadmium ; ou de l'oxyde de zinc comprenant au moins un des éléments choisi parmi l'aluminium, l'indium et le bore.

La première section de contact électrique avant 601a et la seconde section de contact électrique avant 601b peuvent être formées par des techniques de dépôt de couches connues de l'homme du métier. Ces techniques peuvent impliquer des étapes de masquage, de photolithographie et ou de sérigraphie, également connues de l'homme du métier.

La première section de contact électrique avant 601a, et la seconde section de contact électrique avant 601b peuvent être faite chacune d'un matériau différent, de manière à ajuster les résistances de contact, respectivement, entre la première section de contact électrique avant 601a et la première région émettrice 401, et entre la seconde section de contact électrique avant 601b et la seconde région collectrice 501.

Le contact électrique avant 600 comprend également une section de contact métallique avant 602 (il est entendu sans qu'il soit nécessaire de le préciser que la section de contact métallique avant comprend du métal). La section de contact métallique avant 602 relie électriquement la première section de contact électrique avant 601a et la seconde section de contact électrique 601b du contact électrique avant 600. La section de contact métallique avant 602 peut avantageusement comprendre des doigts métalliques avants 602 (« fingers » selon la terminologie Anglo-Saxonne) (figures 3a, 4a, 5a). Les doigts métalliques avants 602 relient chacun la première section de contact électrique avant 601a et la seconde section de contact électrique 601b du contact électrique avant 600. Plus particulièrement, les doigts métalliques 602 relient la surface libre de la première section de contact électrique avant 601a et la surface libre de la seconde section de contact électrique 601b du contact électrique avant 600.

Les doigts métalliques avants 602 du contact métallique avant 600 sont parallèles entre eux.

L'homme du métier, avec ces connaissances générales, peut déterminer la forme, la longueur et l'espacement des doigts métalliques avant 602 du contact métallique avant 600. Pour ces raisons, ces derniers ne sont pas décrits plus en détails dans la présente invention.

Le contact électrique arrière 700 peut comprendre une première section de contact électrique arrière 701a et une seconde section de contact électrique arrière 701b, en contact, respectivement, avec la première région collectrice 402 d'un élément photovoltaïques, dit premier élément photovoltaïques, à la seconde région émettrice 502 d'un autre élément photovoltaïques immédiatement adjacent au premier élément photovoltaïque.

Par définition (sans qu'il soit nécessaire de le préciser), la première section de contact électrique arrière 701a et la seconde section de contact électrique arrière 701b sont en forme de couche de matériau conducteur en recouvrement, au moins partiel, respectivement, de la première région collectrice 402 et de la seconde région émettrice 502.

Il est entendu, qu'au sein d'un même élément photovoltaïques 230, la première section de contact électrique arrière 701a en contact avec la première région collectrice 402 et la seconde section de contact électrique arrière 701b en contact avec la seconde région émettrice 502 n'appartiennent pas au même contact électrique arrière 700.

Au sein d'un même élément photovoltaïques, la première section de contact électrique arrière 701a et la seconde section de contact électrique arrière 701b sont côte-à-côte, et distants d'une distance b2 (figure 3b et 3c).

La distance b2 est strictement positive, et avantageusement comprise entre 0,5 mm et 2 mm.

La première section de contact électrique arrière 701a et la seconde section de contact électrique arrière 701b du contact électrique arrière 700 sont côte-à-côte, et distants d'une distance b2b (figure 3c).

La distance b2b peut être inférieure à 2 mm, voire comprise entre 0 mm et 2 mm, ou encore comprise entre 0,5 mm et 2 mm. De manière avantageuse la distance b2b est nulle ou négative.

La distance b2b peut avantageusement être inférieure à zéro. Plus particulièrement, dès lors que la distance b1b est strictement positive, la distance b2b peut avantageusement être inférieure à zéro.

La première section de contact électrique arrière 701a et la seconde section de contact électrique arrière 701b peuvent, chacune, être formées par une couche d'oxyde transparent conducteur.

La couche d'oxyde transparent conducteur peut comprendre de l'oxyde d'indium, comprenant avantageusement au moins un des éléments choisi parmi l'hydrogène, le tungstène, le cérium, le cadmium ; ou de l'oxyde de zinc comprenant au moins un des éléments choisi parmi l'aluminium, l'indium, le bore.

La première section de contact électrique arrière 701a, et la seconde section de contact électrique arrière 701b peuvent être formées par des techniques de dépôt de couches connues de l'homme du métier. Ces techniques peuvent impliquer des étapes de masquage, de photolithographie et ou de sérigraphie, également connues de l'homme du métier.

La première section de contact électrique arrière 701a, et la seconde section de contact électrique arrière 701b peuvent être faite chacune d'un matériau différent, de manière à ajuster les résistances de contact, respectivement, entre la première section de contact électrique arrière 701a et la première région émettrice 401, et entre la seconde section de contact électrique arrière 701b et la seconde région émettrice 502.

Le contact électrique arrière 700 comprend également une section de contact métallique arrière 702 (il est entendu sans qu'il soit nécessaire de le préciser que la section de contact métallique arrière comprend du métal). La section de contact métallique arrière 702 relient électriquement la première section de contact électrique arrière 701a et la seconde section de contact électrique arrière 701b du contact électrique arrière 700. La section de contact métallique arrière 702 peut avantageusement comprendre des doigts métalliques arrières 702 (« fingers » selon la terminologie Anglo-Saxonne) (figure 4b et 5b). Les doigts métalliques arrières 702 relient chacun la première section de contact électrique arrière 701a et la seconde section de contact électrique arrière 701b du contact électrique arrière 700. Plus particulièrement, les doigts métalliques arrières 702 relient la surface libre de la première section de contact électrique arrière 701a et la surface libre de la seconde section de contact électrique arrière 701b du contact électrique arrière 700.

Les doigts métalliques arrières 702 du contact métallique arrière 700 sont parallèles entre eux.

L'homme du métier, avec ces connaissances générales, peut déterminer la forme, la longueur et l'espacement des doigts métalliques arrières 702 du contact métallique arrière 700. Pour ces raisons, ces derniers ne sont pas décrits plus en détails dans la présente invention.

Les section de contact électrique avant 602 et arrière, et plus particulièrement les doigts métalliques avants 602 et arrière 702, peuvent être réalisées par sérigraphie, et comprendre de l'argent.

Au moins une des premières sections de contact électrique avant 601a peut avoir un de ces côtés adjacent à un bord du substrat support 200. L'espacement entre ledit côté et le bord du substrat 200 est noté : distance c1.

Au moins une des secondes sections de contact électrique avant 602a peut avoir un de ces côtés adjacent à un bord du substrat support 200. L'espacement entre ledit côté et le bord du substrat 200 est noté : distance c2.

Au moins une des premières sections de contact électrique arrière 701a, peut avoir un de ces côtés adjacent à un bord du substrat support 200. L'espacement entre ledit côté et le bord du substrat 200 est noté : distance c3.

Au moins une des secondes sections de contact électrique arrière 701b peut avoir un de ces côtés adjacent à un bord du substrat support 200. L'espacement entre ledit côté et le bord du substrat 200 est noté : distance c4.

Un distance ci (i étant égal à 1, 2, 3 ou 4) est dite positive (supérieure à 0) dès lors que la section de contact électrique concernée est en retrait par rapport au contour 201, et est dite négative (inférieure à 0) dès lors que la section de contact électrique déborde sur le contour 201.

En particulier pour un substrat support dopé n, les distances c1 et c4 peuvent être égales et positives dès lors que la première région émettrice 401 et la seconde région émettrice 502 sont faites de silicium amorphe dopé p, et les distances c2 et c3 peuvent être égales et négatives dès lors que la première région collectrice 402 et la seconde région collectrice 501 sont faites de silicium amorphe dopé n.

De manière réciproque, pour un substrat support dopé p, les distances c1 et c4 peuvent être égales et négative dès lors que la première région émettrice 401 et la seconde région émettrice 502 sont faites de silicium amorphe dopé n, et les distances c2 et c3 peuvent être égales et positives dès lors que la première région collectrice 402 et la seconde région collectrice 501 sont faites de silicium amorphe dopé p.

Le dispositif photovoltaïques 100, selon l'invention, comprend en outre une première région collectrice d'extrémité 402a et une seconde région émettrice d'extrémité 502a.

La première région collectrice d'extrémité 402a est une des premières régions collectrices 402, et la seconde région émettrice d'extrémité 502a est une des secondes régions émettrice 502.

La première région collectrice d'extrémité 402a et la seconde région émettrice d'extrémité 502a sont disposées en extrémité de la chaine de connections électriques en série du ou des d'éléments photovoltaïques. 230. Autrement dit, par définition, la première région collectrice d'extrémité 402a et la seconde région émettrice d'extrémité 502a ne sont l'une et l'autre électriquement connectées à aucune autre, respectivement, seconde région émettrice 502 et première région collectrice 402 du même dispositif via un contact électrique arrière 700.

Ainsi, dès lors que le dispositif photovoltaïques 100, au sens de la présente invention, ne comprend qu'un seul élément photovoltaïques, la première région collectrice d'extrémité 402a et la seconde région émettrice d'extrémité 502a sont, respectivement, la première région collectrice 402 et la seconde région émettrice 502 dudit élément 230 (figure 4b).

La première région collectrice d'extrémité 402a et la seconde région émettrice d'extrémité 502a comprennent respectivement un premier contact d'extrémité 703 et un second contact d'extrémité 704 (figure 4b).

Le premier contact d'extrémité 703 comprend avantageusement une première section de contact électrique d'extrémité 703a en contact avec la première région collectrice d'extrémité 402a, ainsi qu'une première section de contact métallique 703b. La première section de contact métallique 703b comprend par exemple des premiers doigts métalliques 703b disposés parallèlement sur la surface de la première section de contact électrique d'extrémité 703a.

Le second contact d'extrémité 704 comprend avantageusement une seconde section de contact électrique d'extrémité 704a en contact avec la seconde région émettrice d'extrémité 502a, ainsi qu'une seconde section de contact métallique 704b. La seconde section de contact métallique 704b comprend par exemple des seconds doigts métalliques 704b disposés parallèlement sur la surface de la seconde section de contact électrique d'extrémité 704a.

La première section de contact électrique d'extrémité 703a et la seconde section de contact électrique d'extrémité 704a peuvent être formées selon des techniques équivalentes à celles mises en oeuvre pour la formation de la première section de contact électrique arrière 701a, et de la seconde section de contact électrique arrière 701b

Les premiers doigts métalliques 703b et les seconds doigts métalliques 704b peuvent être formés selon des techniques équivalentes à celles mises en oeuvre pour la formation des doigts métalliques arrières 702.

La première région collectrice d'extrémité 402a et la seconde région émettrice d'extrémité 502a sont avantageusement adjacentes au contour 201

Par exemple, dès lors que les premières régions collectrices 402 et les secondes régions émettrices 502 sont agencées en alternance selon une rangée s'étendant selon une direction D de la face arrière 220, la première région collectrice d'extrémité 402a et la seconde région émettrice d'extrémité 502a sont disposées, respectivement, à une première extrémité et à une seconde extrémité de ladite rangée (figure 4b).

Selon un autre exemple, dès lors que les premières régions collectrices 402 et les secondes régions émettrices 502 sont agencées en alternance selon une matrice, la première région collectrice d'extrémité 402a et la seconde région émettrice d'extrémité 502a sont disposées, respectivement, à un premier coin 220a et à un second coin 220b de ladite matrice (figure 5b).

La première région collectrice d'extrémité 402a et la seconde région émettrice d'extrémité 502a peuvent être destinées à la connexion de plusieurs dispositifs photovoltaïques 100 lors de l'assemblage d'un panneau photovoltaïque.

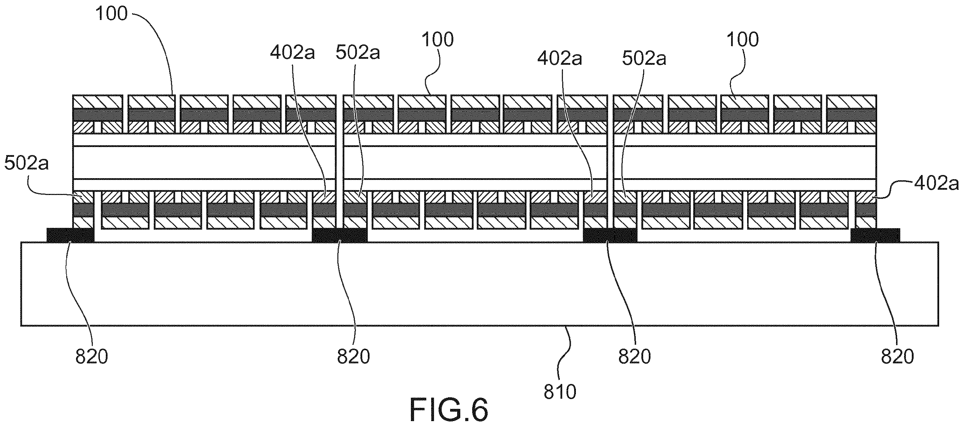

L'invention concerne également un panneau photovoltaïque 800 comprenant des dispositifs photovoltaïques 100 selon l'invention (figure 6).

Le panneau photovoltaïque comprend un support 810 sur lequel sont disposés une pluralité de dispositifs photovoltaïques 100.

Le support 810 peut comprendre au moins un des matériaux choisi parmi : un matériau polymère transparent, verre.

Au moins un contact additionnel 820 est disposé sur le panneau photovoltaïque et destiné à connecter électriquement le premier contact d'extrémité 703 d'un premier dispositif photovoltaïque 100, avec le second contact d'extrémité 704 d'un autre dispositif photovoltaïque 100 adjacent au premier dispositif photovoltaïque.

Le contact additionnel 820 peut comprendre au moins un des matériaux choisi parmi : Cuivre, argent, étain, indium.

Le contact additionnel peut être sous forme de ruban, de fils, de colles

Ainsi, lors de l'assemblage du panneau photovoltaïque, il n'est pas nécessaire de disposer des rubans conducteurs connectant la face avant d'une cellule photovoltaïque à la face arrière d'une autre cellule photovoltaïque, ni même de connecter entre eux sur une face les dispositifs photovoltaïques 100, avantageusement la face avant.

L'agencement des cellules photovoltaïques permet à la fois de fiabiliser le panneau photovoltaïque selon l'invention, mais également de simplifier son procédé d'assemblage.

Par ailleurs, le dispositif photovoltaïque 100, selon la présente invention, permet également de réduire l'espacement entre les première et seconde cellules photovoltaïques, mais également entre deux dispositifs photovoltaïques adjacents. Les zones blanches sont ainsi réduites, permettant ainsi d'améliorer l'efficacité du panneau photovoltaïque.

La considération de première et seconde cellule photovoltaïques de plus petite taille permet également de s'affranchir de la formation de busbar (un busbar est un jeu de conducteurs disposés sur une face d'une cellule photovoltaïque, et destiné à relier électriquement une série de contacts électriques parallèles entre eux et au contact de ladite face de la cellule).

En outre, il est également possible de considérer des cellules de plus petite taille sans pour autant devoir exécuter des étapes de découpe supplémentaires desdites cellules avant l'assemblage d'un panneau photovoltaïque, et ainsi éviter toute défectivité qui pourrait être associée à ce type d'étape.

Enfin, le panneau photovoltaïque selon l'invention est bifacial, autrement dit ledit panneau peut convertir de l'énergie lumineuse, incidente sur une face avant et sur une face arrière, en énergie électrique (tension et courant). A cet égard, le support 810 doit être transparent, par exemple fait de polymère transparent ou verre.

L'invention concerne en outre un procédé de fabrication du dispositif photovoltaïque 100, et qui reprend pour l'essentiel toutes les étapes de procédé précédemment décrites. Plus particulièrement, le procédé selon l'invention reprend des étapes de formation de la première région émettrice 401, de la première région collectrice 402, de la seconde région émettrice 502, de la seconde région collectrice 501, par une technique de dépôt de film, par exemple par la technique PECVD.

De manière équivalente, dès lors qu'elle est requise, la couche de passivation 300 peut être également formée par PECVD.

Toujours de manière équivalente, les premières sections de contact électrique avant 601a et arrière 701a, ainsi que les secondes sections de contact électrique avant 601b et arrière 701b peuvent être formées par plusieurs techniques de dépôt physique ou chimique, en phase vapeur ou non, assisté par plasma ou non, ou par dépôt d'impression.

Ainsi, le procédé de fabrication comprend une étape a) qui consiste à fournir le substrat support 200.

Le procédé comprend également une étape b) de formation de l'au moins une première région émettrice 401 et de l'au moins une seconde région collectrice 501, de préférence de forme polygonale, côte-à-côte et en alternance, sur la face avant 210.

Le procédé comprend en outre une étape c) de formation de l'au moins une première région collectrice 402 et de l'au moins une seconde région émettrice 502, de forme polygonale, sur la face arrière 220, et au droit, respectivement, de l'au moins une première région émettrice 401 et de l'au moins une seconde région collectrice 501.

Enfin, le procédé de fabrication comprend une étape d) qui consiste à former l'au moins un contact électrique avant 600 reliant l'au moins une première région collectrice 401 avec l'au moins une seconde région émettrice 501

Le procédé peut en outre comprendre une étape e) qui consiste à former au moins un contact électrique arrière 700. De manière avantageuse, le procédé peut comprendre en outre une étape a1) de formation de la couche de passivation 300 recouvrant intégralement le substrat support 200 et de sorte que les au moins une première région émettrice 401 et collectrice 402 et les au moins une seconde région émettrices 502 et collectrice 501 reposent sur ladite couche de passivation 300.

## Revendications

1. Dispositif photovoltaïque (100) comprenant :
- un substrat support (200) qui comprend deux faces essentiellement parallèles dites, respectivement, face avant (210) et face arrière (220),
- au moins un élément photovoltaïque (230) comprenant une première cellule photovoltaïque à hétérojonction (410) et une seconde cellule photovoltaïque à hétérojonction (510), la première cellule photovoltaïque à hétérojonction (410) comprenant une première région émettrice (401) et une première région collectrice (402) disposées, respectivement, sur la face avant (210) et sur la face arrière (220) du substrat support (200), la seconde cellule photovoltaïque à hétérojonction (510) comprenant une seconde région collectrice (501) et une seconde région émettrice (502) disposées, respectivement, sur la face avant (210) et sur la face arrière (220) du substrat la première cellule photovoltaïque à hétérojonction (410) et la seconde cellule photovoltaïque à hétérojonction (510) étant disposées côte-à-côte, et électriquement connectées au moyen d'un contact électrique avant (600) reliant la première région émettrice (401) avec la seconde région collectrice (501),
- l'au moins un élément photovoltaïque comprend en outre une première section de contact électrique arrière (701a) et une seconde section de contact électrique arrière (701b) formées, respectivement, sur la première région collectrice (402) et la seconde région émettrice (502), et lesdites première et seconde sections de contact électrique étant espacées l'une de l'autre d'une distance b2 strictement positive et comprennent une couche en oxyde conducteur transparent.

2. Dispositif selon la revendication 1, dans lequel le dispositif comprend une pluralité d'éléments photovoltaïques (230) électriquement connectés en série par au moins un contact électrique arrière (700), chaque contact électrique arrière (700) connectant électriquement la première région collectrice (402) d'un élément photovoltaïque, dit premier élément photovoltaïque, à la seconde région émettrice (502) d'un autre élément photovoltaïque immédiatement adjacent au premier élément photovoltaïque.

3. Dispositif selon la revendication 2, dans lequel le contact électrique arrière (700) comporte la première section de contact électrique arrière (701a) et la seconde section de contact électrique arrière (701b), en contact, respectivement, avec la première région collectrice (402) d'un élément photovoltaïque, dit premier élément photovoltaïque, à la seconde région émettrice (502) d'un autre élément photovoltaïque immédiatement adjacent au premier élément photovoltaïque, chaque contact électrique arrière (700) comprend également une section de contact métallique arrière (702) qui relie la première section de contact électrique arrière (701a) et la seconde section de contact électrique arrière (701b) dudit contact électrique arrière (700), avantageusement la section de contact métallique arrière (702) comprend des doigts métalliques arrières.

4. Dispositif selon l'une des revendications 1 à 3, dans lequel le contact électrique avant (600) comprend une première section de contact électrique avant (601a) et une seconde section de contact électrique avant (601b), en contact, respectivement, avec la première région émettrice (401), et la seconde région collectrice (501) d'un élément photovoltaïque (230), le contact électrique avant (600) comprend en outre une section de contact métallique avant (602) qui relie la première section de contact électrique avant (601a) et la seconde section de contact électrique (601b) dudit contact électrique avant (600), avantageusement la section de contact métallique avant (602) comprend des doigts métalliques avants (602).

5. Dispositif selon la revendication 4, dans lequel la première section de contact électrique avant (601a) et la seconde section de contact électrique avant (601b) sont formés par une couche en oxyde conducteur transparent, de manière avantageuse, l'oxyde conducteur transparent comprend au moins un des matériaux choisi parmi : de l'oxyde d'indium comprenant avantageusement au moins un des éléments choisi parmi : l'étain, l'hydrogène, le tungstène, le cérium, le cadmium,; ou de l'oxyde de zinc comprenant au moins un des éléments choisi parmi : l'aluminium, l'indium, le bore.

6. Dispositif selon l'une des revendications 1 à 5, dans lequel le substrat support (200) est intégralement recouvert d'une couche de passivation (300) de sorte que les premières régions émettrice (401) et collectrice (402) et les secondes régions émettrice (502) et collectrice (501) reposent sur ladite couche de passivation (300), avantageusement, la couche de passivation (300) comprend du silicium amorphe, encore plus avantageusement le silicium amorphe comprend un niveau de dopage inférieur à 10²⁰ at/cm³, notamment le silicium amorphe est intrinsèque.

7. Dispositif selon l'une des revendications 1 à 6, dans lequel la première région émettrice (401) et la seconde région collectrice (501) de l'élément photovoltaïque (230) sont espacées d'une distance a1 inférieure à 2 mm, avantageusement d'une distance nulle.

8. Dispositif selon l'une des revendications 1 à 7, dans lequel la première région collectrice (402) et la seconde région émettrice (502) de l'élément photovoltaïque sont espacées d'une distance a2 inférieure à 2 mm, avantageusement d'une distance égale à 1 mm.

9. Dispositif selon l'une des revendications 1 à 8 en combinaison avec la revendication 5 ou 6, dans lequel la première section de contact électrique avant (601a) et la seconde section de contact électrique avant (601b) du contact électrique avant (600) sont espacées d'une distance b1 comprise entre 0 mm et 2 mm, avantageusement nulle.

10. Dispositif selon l'une des revendications 1 à 9, dans lequel les surfaces de l'au moins une première région émettrice (401), de l'au moins une seconde région collectrice (402), de l'au moins une seconde région collectrice (501) et de l'au moins une seconde région émettrice (502) sont ajustées de sorte que la première cellule photovoltaïque et la seconde cellule photovoltaïque présentent des performances équivalentes.

11. Panneau photovoltaïque comprenant un support sur lequel sont disposés une pluralité de dispositifs photovoltaïques (100) selon l'une des revendications 1 à 10 , le panneau photovoltaïque comprenant au moins un contact additionnel connectant électriquement une première région collectrice d'extrémité d'un dispositif photovoltaïque (100), dit premier dispositif photovoltaïque (100), avec une seconde région émettrice d'extrémité (502a) d'un autre dispositif photovoltaïque (100) adjacent au premier dispositif photovoltaïque (100), La première région collectrice d'extrémité (402a) étant une région collectrice (402) disposée en extrémité de la chaine de connections électriques en série du premier dispositif photovoltaïque (100), et la seconde région émettrice d'extrémité (502a) étant disposée en extrémité de la chaine de connections électriques en série de l'autre dispositif photovoltaïque.

12. Procédé de fabrication du dispositif photovoltaïque (100) selon l'une des revendications 1 à 10, le dispositif photovoltaïque (100) comprenant une première cellule photovoltaïque à hétérojonction (410) et une seconde cellule photovoltaïque à hétérojonction (510), la première cellule photovoltaïque à hétérojonction (410) comprenant une première région émettrice (401) et une première région collectrice (402) disposées, respectivement, sur une face avant (210) et sur une face arrière (220) d'un substrat support (200), la seconde cellule photovoltaïque à hétérojonction (510) comprenant une seconde région collectrice (501) et une seconde région émettrice (502) disposées, respectivement, sur la face avant (210) et sur la face arrière (220), le procédé comprenant les étapes suivantes :
a) Une étape qui consiste à fournir le substrat support (200) comprenant deux faces essentiellement parallèles, dites face avant (210) et face arrière (220),
b) une étape qui consiste à former la première région émettrice (401) et la seconde région collectrice (501) sur la face avant (210),
c) une étape qui consiste à former la première région collectrice (402) et la seconde région émettrice (502) sur la face arrière (220),
d) une étape qui consiste à former au moins un contact électrique avant (600) reliant la première région collectrice (402) avec la seconde région émettrice (502).

13. Procédé selon la revendication 12, dans lequel le dispositif photovoltaïque comprend une pluralité d'éléments photovoltaïques (230), le procédé comprenant une étape e) qui consiste à former au moins un contact électrique arrière (700), le contact électrique arrière (700) connectant électriquement la première région collectrice (402) d'un élément photovoltaïque, dit premier élément photovoltaïque, à la seconde région émettrice (502) d'un autre élément photovoltaïque immédiatement adjacent au premier élément photovoltaïque.

14. Procédé selon la revendication 12 ou 13, dans lequel le procédé comprend en outre une étape a1) de formation d'une couche de passivation (300) recouvrant intégralement le substrat support (200) et de sorte que les premières régions émettrice (401) et collectrice (402) et les secondes régions émettrice (502) et collectrice (501) reposent sur ladite couche de passivation (300), avantageusement, la couche de passivation (300) est une couche de silicium amorphe formée par une technique de dépôt chimique en phase vapeur assisté par plasma.
